# EUROPEAN PATENT APPLICATION

(11) **EP 2 696 384 A1**
(43) Date of publication of application: **12.02.2014**
(21) Application number: 12767891.0
(22) Date of filing: 25.01.2012
(51) Int. Cl.: H01L 51/42, H01L 51/50, H05B 33/02, H05B 33/26

(54) **ELECTRODE SHEET FOR ORGANIC DEVICE, ORGANIC DEVICE MODULE, AND METHOD FOR PRODUCING SAME**

(30) Priority: 05.04.2011 JP 2011083901
(71) Applicant: Mitsui Mining & Smelting Co., Ltd, Shinagawa-ku Tokyo 141-8584 (JP)
(72) Inventor: MATSUURA Yoshinori, Tokyo 141-8584 (JP)
(74) Representative: Potter Clarkson LLP
(86) International application number: PCT/JP2012/051547
(87) International publication number: WO 2012/137525

(57) **Abstract**

There is provided an electrode sheet for organic device capable of, only by cutting, providing desired organic device elements with a high degree of freedom in shape without causing damage, which has both the functions of a supporting base material and an organic semiconductor and also has a superior humidity resistance, oxygen impermeability, flexibility, low resistivity and mass productivity. The electrode sheet for organic device comprises a metal foil; and a plurality of organic semiconductor layers provided apart from each other on said metal foil.

## Description

### CROSS-REFERENCE TO RELATED APPLICATION

This application claims priority to Japanese Patent Application No. 2011-83901 filed on April 5, 2011, the entire disclosure of which is incorporated herein by reference.

### TECHNICAL FIELD

The present invention relates to electrode sheets for organic device using metal foils. Furthermore, the present invention relates to organic device modules using the electrode sheets for organic device, such as organic EL elements, organic solar cells or the like, and methods for producing the same.

### BACKGROUND ART

There are mainly three types of solar cells, namely silicon-based solar cells, compound-based solar cells and organic solar cells. Among them, organic solar cells, particularly organic-thin-film type and dye-sensitization type organic solar cells, are light weight and flexible, and have the advantage of low production energy and low production cost.

One of the advantages of organic solar cells is that process temperature can be lowered. Therefore, resin films such as polyimide (PI) and polyethylene terephthalate (PET) can be used as substrates, and this allows preparation of thin and flexible organic solar cells.

However, since most of the organic solar cells are active in water and oxygen, there is the problem of decreasing properties in the presence of water and oxygen. In order to address this problem, it is necessary not to laminate organic solar cells directly on PI or PET films which have low humidity resistance but to laminate active layers of organic solar cells after having covered with inorganic insulating films such as SiNx, SiOx, SiON or the like, and this induces increase of production cost.

In view of this, currently, organic solar cells are mainly formed on glass substrates. Although the glass substrates have high reliability with respect to humidity resistance and oxygen impermeability, they are poor in flexibility. As a result, in reality, the organic solar cells formed on glass substrates cannot use the advantage of flexible organic solar cells. Even if thin glass plates are used as substrates of the organic solar cells in order to attain flexibility, it is difficult to ensure mass productivity of the organic solar cells since glass is easy to produce chip, crack or the like which becomes undesirable particles. Furthermore, since it is difficult to change shape of the glass freely, the shape cannot be selected freely and is basically always quadrangular.

Furthermore, in order to ensure desired voltage, the organic solar cells have a structure in which a plurality of cells are electrically series-connected. Therefore, a photolithography process is necessary to form, on the same substrate, a plurality of cells and a plurality of electrical wirings that make an electrical series-connection between the cells. For this reason, manufacturing processes become complicated and induce increase of production cost. Moreover, there is a concern that, due to the presence of only one defective cell among a plurality of series-connected cells, properties of the whole organic solar cells deteriorate.

For example, Patent Literature 1 discloses an optoelectronic device module provided with a plurality of optoelectronic devices on a substrate.

### CITATION LIST

### [Patent Literature]

[Patent Literature 1] JP2008-529281A

### SUMMARY OF INVENTION

The inventors have currently found that providing an organic semiconductor layer on a metal foil enables attainment of an electrode sheet for organic device suitable for mass production by roll-to-roll process, which has both the functions of a supporting base material and an organic semiconductor and also has a superior humidity resistance, oxygen impermeability, flexibility and low resistivity. Moreover, providing a plurality of organic semiconductor layers apart from each other on a metal foil makes it possible to cut out each desired organic device element with a high degree of freedom in shape without damaging the organic semiconductor layer, and thus to easily obtain a plurality of organic device elements which are series-connectable to each other, without a photolithography process. Furthermore, since each organic device element can be cut, a defective element can be removed beforehand.

It is thus an object of the present invention to provide an electrode sheet for organic device capable of, only by cutting, providing desired organic device elements with a high degree of freedom in shape without causing damage, which has both the functions of a supporting base material and an organic semiconductor and also has a superior humidity resistance, oxygen impermeability, flexibility, low resistivity and mass productivity; an organic device module using the electrode sheet for organic device and a method for producing the same.

According to an aspect of the present invention, there is provided an electrode sheet for organic device comprising:
a metal foil;
a plurality of organic semiconductor layers provided apart from each other on said metal foil.

According to another aspect of the present invention, there is provided an organic device module comprising a plurality of organic device elements on an insulating substrate, the plurality of organic device elements having been obtained by cutting the electrode sheet at separation sections between said organic semiconductor layers.

According to still another aspect of the present invention, there is provided a method for producing an organic device module comprising the steps of:
cutting the electrode sheet at separation sections between said organic semiconductor layers to form a plurality of organic device elements; and
arranging the plurality of organic device elements on an insulating substrate.

### BRIEF DESCRIPTION OF DRAWINGS

Fig. 1 is a schematic cross-sectional view illustrating an example of the electrode sheet according to the present invention.
Fig. 2 is a schematic cross-sectional view of another example of the electrode sheet according to the present invention.
Fig. 3 is a schematic view illustrating an example of the manufacturing process of the electrode sheet according to the present invention.
Fig. 4 is a schematic view illustrating an example of the organic device module using the electrode sheet according to the present invention.
Fig. 5 is a schematic view illustrating an example of the cell that constitutes the organic device modules using the electrode sheet according to the present invention.
Fig. 6 is a schematic cross-sectional view illustrating an example of the electrode sheet according to the present invention.

### DESCRIPTION OF EMBODIMENT

### Electrode sheet

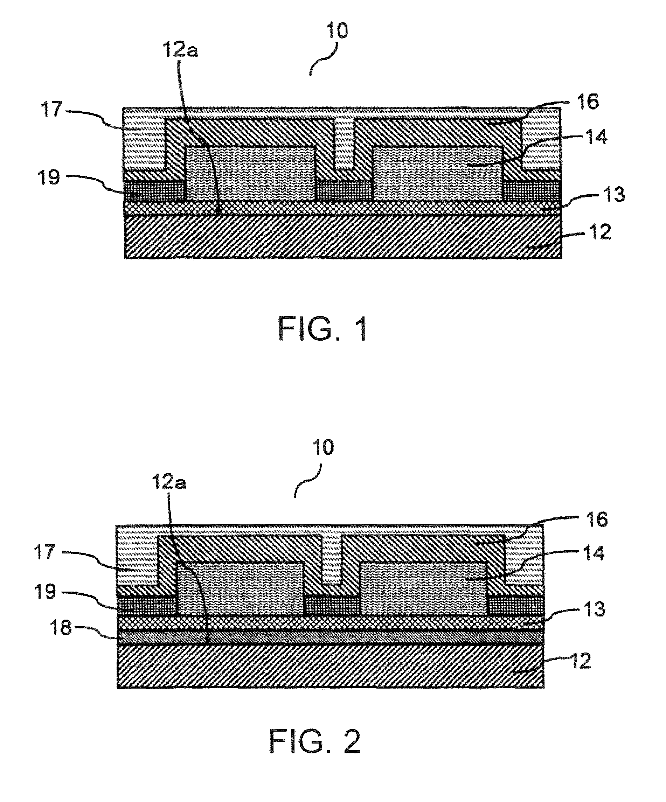

Fig. 1 shows a schematic cross-sectional view of an example of the electrode sheet 10 according to the present invention. The electrode sheet 10 shown in Fig. 1 comprises a metal foil 12; a buffer layer 13 provided directly on the metal foil 12; a plurality of organic semiconductor layers 14 provided apart from each other directly on the buffer layer 13; an interlayer insulation film 19 provided between adjacent organic semiconductor layers 14; a counter electrode 16 provided to cover the surface of organic semiconductor layers 14; and a sealing material 17 provided to cover the surface of counter electrode 16. Furthermore, Fig. 2 shows a schematic cross-sectional view of another example of the electrode sheet 10 according to the present invention. The electrode sheet 10 shown in Fig. 2 has the same structure as the electrode sheet 10 shown in Fig. 1 except for comprising a reflective layer 18 between the metal foil 12 and the buffer layer 13.

Although the electrode sheet 10 shown in Figs. 1 and 2 has a five-layer structure or a six-layer structure composed of the metal foil 12, optionally the reflective layer 18, the buffer layer 13, the organic semiconductor layers 14, the counter electrode 16 and the sealing material 17, the electrode sheet of the present invention is not limited thereto. It may have various forms such as a two-layer structure composed of the metal foil 12 and the organic semiconductor layers 14; a three-layer structure composed of the metal foil 12, the buffer layer 13 and the organic semiconductor layers 14; and a four-layer structure composed of the metal foil 12, the buffer layer 13, the organic semiconductor layers 14 and the counter electrode 16. Furthermore, if desired, a sealing film may be formed between the counter electrode 16 and the sealing material 17. In all of these forms, the metal foil 12 and the organic semiconductor layers 14 can make electrical contact with each other directly or indirectly, thereby ensuring that the metal foil 12 serves a function in not only a supporting base material but also an electrode. The direct electrical contact is attained by providing the organic semiconductor layers 14 directly on the metal foil 12 while the indirect electrical contact is attained by allowing electrical contact with the organic semiconductor layers 14 through other functional layers, such as the buffer layer 13 and the reflective layer 18, on the metal foil 12. Figs. 1 and 2 are schematic views for the purpose of description and understanding of the embodiments. Shapes, dimensions, ratios, and the like in the views can appropriately be changed by taking the following descriptions and known techniques into consideration.

As shown in Figs. 1 and 2, the plurality of organic semiconductor layers 14 are provided apart from each other on the metal foil 12, and a distance between adjacent organic semiconductor layers 14 is not particularly limited as long as a distance that is necessary for a cutting process may be reserved (e.g. a distance for a blade to pass through a separation section without damaging the organic semiconductor layers 14). Furthermore, the surface shape of the organic semiconductor layers 14 can be selected freely from tetragon, circle or the like and may be formed in various patterns such as stripe state, matrix state, island state. When this electrode sheet 10 is used as a component of an organic solar cell, the surface area of each organic semiconductor layer 10 is preferred to be about 5mm-square because if the surface area of the organic semiconductor layers 10 that serves generally as a light-receiving section becomes large, power generation efficiency decreases.

The counter electrode 16 is provided to cover the surface of the organic semiconductor layer or the plurality of organic semiconductor layers 14, and the number of the organic semiconductor layer 14 covered with one counter electrode 16 can be selected adequately. Furthermore, for preparation of an organic device module, at the end of the counter electrode 16, there is preferably provided an extraction electrode electrically connected with the counter electrode 16 not to make contact with the organic semiconductor layers 14. In this case, the sealing material 17 provided on the counter electrode 16 is preferably provided to cover the counter electrode 16 on the organic semiconductor layers 14 and to expose the extraction electrode at the end of the counter electrode 16.

The metal foil 12 is not particularly limited as long as the metal foil is a foil-like metallic material that has a strength required for a supporting base material and electrical properties required for an electrode. A preferred metal foil 12 is a nonmagnetic metal foil from the view point of preventing magnetic adherence of particles produced on machining. Examples of the nonmagnetic metal preferably include copper, aluminum, nonmagnetic stainless steel, titanium, tantalum, and molybdenum, and more preferably copper, aluminum, and nonmagnetic stainless steel. The most preferable metal foil is copper foil. Copper foil is relatively inexpensive as well as excellent in strength, flexibility, humidity resistance, oxygen impermeability and electrical properties. Furthermore, copper foil has high reflectivity to long-wavelength light, and when a reflection film, particularly the electrode sheet 10, is used as a solar cell copper foil has preferable properties as the reflection film.

When graphene is used as the buffer layer 13, a metal foil made of copper, nickel and iron is preferably used as the metal foil 12, since these metals act as a catalyst during formation of graphene. Furthermore, copper foil is more preferably used as the metal foil 12, since copper has property of being less likely to cause ion diffusion during formation of graphene, as compared to the other metals.

The surface 12a of the metal foil 12, on which the organic semiconductor layer 14 and the like are to be provided, is preferably an ultra-smooth surface having an arithmetic average roughness Ra of 10.0 nm or less, more preferably 7.0 nm or less, further preferably 5.0 nm or less, most preferably 3.0 nm or less. The lower limit of the arithmetic average roughness Ra is not particularly limited but may be 0 (zero). However, considering efficiency of surface smoothing treatment, 0.5 nm may be considered the lower limit. The arithmetic average roughness Ra may be measured in accordance with JIS B 0601-2001 by using a commercially available surface roughness meter.

Since the organic semiconductor layers 14 and the like are laminated, in the case that the surface 12a of the metal foil 12 is not the outermost surface, the arithmetic average roughness Ra of the metal foil surface 12a may be evaluated by creating a cross section from the surface of electrode sheet 10 by FIB (Focused Ion Beam) processing; and observing the cross section with a transmission electron microscope (TEM).

As far as the present inventors are aware, a metal foil 12 (particularly, a copper foil) having the aforementioned ultra-smooth surface 12a has not been industrially produced to date, nor has there been any attempt to apply the metal foil to a member composing organic devices such as organic EL elements, organic solar cells or the like. A copper foil with a smoothed surface is commercially available, but such a surface smoothness level of the copper foil is not sufficient for a component of an organic device, and may result in short circuit due to the unevenness and thus fails to provide desired property. In contrast, when the arithmetic average roughness Ra of the ultra-smooth surface 12a of the metal foil 12 is extremely small, short circuit that otherwise may occur between the electrodes can be effectively prevented, even if the foil is used as a component of an organic device.

Such an ultra-smooth surface 12a may be attained by polishing the metal foil 12 with CMP (Chemical Mechanical Polishing) treatment. CMP treatment may be performed by using a known polishing liquid and a known polishing pad under known conditions. A preferable polishing liquid may comprises one or more of polishing granules selected from ceria, silica, alumina, zirconia, and others in an amount of from about 0.5 to about 2 wt%; an oxidizing agent such as benzotriazole (BTA); and/or an organic complex forming agent such as quinaldic acid, quinolinic acid, and nicotinic acid; a surfactant such as a cationic surfactant and an anionic surfactant; and optionally an anticorrosive agent. A preferable polishing pad is a pad made of urethane. The polishing conditions are not particularly limited as pad rotation speed, work load, coating flow rate of polishing liquid may be adequately regulated. It is preferable that the rotation speed be regulated in the range of from 20 rpm to 1,000 rpm, that the work load be regulated in the range of from 100 gf/cm² to 500 gf/cm², and that a coating flow rate of the polishing liquid be regulated in the range of from 20 cc/min to 200 cc/min.

The ultra-smooth surface 12a may be attained by polishing metal foil 12 using electrolytic polishing, buff polishing, chemical polishing, or a combination thereof. Chemical polishing is not particularly limited as it may be performed by adequately adjusting a chemical polishing solution, the temperature of the chemical polishing solution, dipping time in the chemical polishing solution, and the like. For instance, chemical polishing of copper foil may be performed by using a mixture of 2-aminoethanol and ammonium chloride. The temperature of the chemical polishing solution is preferably room temperature, while dipping method (Dip process) is preferably used. Further, dipping time in the chemical polishing solution is preferred to be from 10 to 120 seconds, more preferably from 30 to 90 seconds since long dipping time tends to result in degradation of smoothness. The metal foil 12 after chemical polishing is preferred to be cleansed with running water. This smoothing treatment can smooth the surface having an arithmetic average roughness Ra of about 12 nm to have an Ra of 10.0 nm or less.

The ultra-smooth surface 12a may also be attained by a technique such as a method of polishing the surface of the metal foil 12 by blasting or a method of melting the surface of the metal foil 12 by laser, resistance heating, lamp heating or the like and then rapidly cooling the surface of the metal foil 12. In the case of using, as the metal foil 12, a platable foil made of a metal such as copper, nickel, and chromium, the ultra-smooth surface may also be attained by using a transfer method. The transfer method may be conducted in accordance with known techniques and known conditions. For instance, the surface of an electrode plate such as SUS and titanium is smoothed by electrolytic polishing and buff polishing so as to be provided with an arithmetic average roughness Ra of 10.0 nm or less. The surface of the electrode plate thus smoothed was plated with the material of metal foil 12, which is peeled off from the electrode plate when a desired thickness is attained. In this way, by transferring the smoothness of the electrode plate surface to the peeled face of the metal foil 12, an ultra-smooth surface 12a can be attained.

The thickness of the metal foil 12 is not particularly limited as long as the metal foil does not lose flexibility and can be handled solely in itself, but may be in the range of from 1 µm to 200 µm, preferably from 10 µm to 150 µm, and more preferably from 20 µm to 100 µm. With such thickness, cutting may be performed easily by using a commercially available cutting machine. Since the electrode sheet 10 uses the metal foil 12 as a base, it can be formed in various shapes other than tetragon, such as circle, triangle, and polygon. Moreover, unlike glass substrates, the electrode sheet 10 has no problems of crack, chip or the like when cutting and also has an advantage of being less likely to produce particles upon cutting.

The ultra-smooth surface 12a is preferably cleansed with an alkaline solution. A known alkaline solution such as an ammonia-containing solution, a sodium hydroxide solution, and a potassium hydroxide solution may be used as the alkaline solution. The alkaline solution is preferably an ammonia-containing solution, more preferably an organic alkaline solution containing ammonia, further preferably a tetramethylammonium hydroxide (TMAH) solution. Preferable concentration of the TMAH solution is from 0.1 wt% to 3.0 wt%. An example of washing described above includes performing cleansing at 23°C for one minute with use of a 0.4 % TMAH solution. A similar cleansing effect can also be attained by performing UV (Ultra Violet) treatment in combination with or in place of the alkaline solution. In addition, in the case of copper foil and the like, it is possible to remove oxides formed on the copper surface by using an acidic cleansing solution such as dilute sulfuric acid. An example of acid cleansing includes performing cleansing for 30 seconds with dilute sulfuric acid.

Prior to the formation of the organic semiconductor layer 14 and the like, it is preferred that particles on the ultra-smooth surface 12a be removed. Examples of an effective method for removing the particles include a sonic washing method using ultra-pure water and a dry-ice blasting method. The dry-ice blasting method is more effective. Dry-ice blasting method is a method of ejecting carbon dioxide gas compressed at high pressure through a fine nozzle and thereby blowing carbon dioxide solidified at low temperature against the ultra-smooth surface 12a to remove the particles. Unlike wet process, this dry-ice blasting method can dispense with drying process, and also has an advantage of being able to remove organic substances. The dry-ice blasting method may be performed by using a commercially available apparatus such as a dry-ice snow system (manufactured by AIR WATER INC.).

A buffer layer 13 may be provided on the metal foil 12 as desired. The buffer layer 13 is not particularly limited as long as it makes contact with the organic semiconductor layers 14 in an organic solar cell or an organic EL element to improve hole injection efficiency, electron injection efficiency or the like as well as to provide a desired work function. Nonetheless, the buffer layer 13 in the present invention is preferably transparent or translucent from the viewpoint of enabling the metal foil 12 to function as a reflective layer.

The buffer layer 13 is preferably at least one selected from the group consisting of a conductive carbon material film, a conductive oxide film, a magnesium alloy film, and a fluoride film, and may be selected as needed depending on applications such as an anode or a cathode and required performances.

As the conductive carbon material film, a graphene film; or various kinds of amorphous carbon films provided with electrical conductivity by regulating hydrogen concentration or impurity concentration may be used.

As the graphene film, a laminated film comprising graphene which is arranged preferably in five-layer or less, more preferably in three-layer or less, further preferably in one-layer may be used. As a method for forming graphene, various known techniques such as CVD (Chemical Vaper Deposition) using µ wave; thermal (high-temperature) CVD; or a method for forming by liquid-plasma which applies high voltage in ethanol may be used. For example, graphene film can be obtained by heating the metal foil 12 to 1,000 °C, and keeping at a flow rate of CH₄/H₂ = 25/10sccm and a pressure of 0.5 Torr for 30 minutes before cooling at a rate 10 °C/sec under hydrogen atmosphere at a pressure of 0.1 Torr. The formation of the graphene film is confirmed generally by measuring Raman spectrum. In particular, the measured Raman spectrum has desirably the ratio of 2D band to G band of 1 or more.

When the graphene film is thus provided as the buffer layer 13 on the metal foil 12, as described above, the metal foil 12 comprising the metallic material which acts as a catalyst during formation of graphene film, such as nickel foil, iron foil and copper foil, is preferably used. Furthermore, copper foil is more preferably used. Copper foil is relatively inexpensive as well as excellent in strength, flexibility, humidity resistance, oxygen impermeability and electrical properties, and, in addition, it has property of being less likely to cause carbon ion diffusion during formation of graphene film, as compared to the other metals.

Further, by forming the graphene film as the buffer layer 13 on the ultra-smooth surface 12a of the metal foil 12 having an extremely small arithmetic average roughness Ra as described above, a graphene film having high crystal continuity, namely, a graphene film having high conductivity can be attained.

Formation of the conductive amorphous carbon film is preferred to be conducted by sputtering. A carbon target subjected to purification treatment is desired to be used for the sputtering. In addition, porous carbon impregnated with B, Si, Al or Cu may be used. When the conductive amorphous carbon film is used as the buffer layer 13, any of an aluminum film, an aluminum alloy film, a silver film, and a silver alloy film may be suitably used for the reflective layer 18, while aluminum alloys are preferable in consideration of smoothness and material cost.

A preferable conductive amorphous carbon film is composed of an conductive amorphous carbon having a hydrogen concentration of 15 at% or less. The hydrogen concentration is more preferably 12 at% or less and further preferably 5 at% or less. Although the lower limit of the hydrogen concentration is not particularly limited but may be 0 (zero), a typical lower limit may be 3 at% in consideration of unavoidable contamination with hydrogen from film forming environment upon sputtering. The hydrogen concentration in the buffer layer 13 may be measured by various known methods, among which HFS (Hydrogen Forward Scattering) is preferred. The hydrogen concentration in the conductive amorphous carbon film is defined herein as a hydrogen concentration obtained by measuring the amounts of carbon and hydrogen by HFS or the like and assuming the total amount of these atoms as 100 at%. Extremely lowering the hydrogen concentration in this way makes it possible to avoid decrease in electrical conductivity or development of insulation properties, which are caused by the carbon atoms constituting the buffer layer 13 being terminated with hydrogen, and thus to provide the buffer layer 13 with a high electrical conductivity required for an electrode. Therefore, it is preferable that the conductive amorphous carbon be not substantially doped with impurities other than carbon and hydrogen. The phrase "not substantially doped" means that impurities are not intentionally added for the purpose of providing a certain function, allowing impurities unavoidably incorporated from film forming environment or the like during sputtering. In view of this, the conductive amorphous carbon in the present invention preferably has an oxygen concentration of from 0 wtppm to 300 wtppm, a halogen element concentration of from 0 wtppm to 1,000 wtppm, and a nitrogen concentration of from 0 wtppm to 500 wtppm. The thickness of the buffer layer 13 is not particularly limited, but preferably from 3 nm to 30 nm, more preferably from 3 nm to 15 nm, and further preferably from 5 nm to 10 nm.

A preferable conductive oxide film may be composed of one or more selected from the group consisting of InOₓ, SnOₓ, ZnOₓ, MoOₓ, GaOₓ, VOₓ, WOₓ, RuOₓ, AlOₓ, TiOₓ, and GeOₓ. Typical examples thereof include ITO (indium tin oxide) and IZO (indium zinc oxide). The conductive oxide film may be formed by using a known technique such as sputtering and vacuum deposition, preferably DC magnetron sputtering. The target material used for sputtering may be prepared by hot pressing or cold pressing, so that the oxides described above may be combined together as needed to attain desired characteristics. When the conductive oxide film is used as the buffer layer, Al-Ni alloys, Ag, and Ag alloy are particularly suitable for the reflective layer.

A preferable magnesium alloy film may be composed of an alloy comprising Mg and one or more additive selected from the group consisting of Ag, Al, Zn, Li, Y, and Ca. The magnesium alloy film may be formed by using a known technique such as sputtering method or vacuum deposition method, preferably vacuum deposition method.

A preferable fluoride film may be composed of one or more selected from the group consisting of LiF, MgF₂, CaF₂, AlF₃, Na₃AlF₆, and NaF₆. The fluoride film may be formed by using a known technique such as sputtering method or vacuum deposition method, preferably vacuum deposition method.

As described above, since the buffer layer 13 is formed on the ultra-smooth metal foil 12 in the electrode sheet 10 of the present invention, it is possible to provide a small arithmetic average roughness Ra even on the surface of the buffer layer 13 and thus to attain a higher smoothness. This enables reduction in risk of short circuit between the metal foil 12 and the counter electrode 16, which may be caused by occurrence of excessive unevenness. In addition, since there is no need to thickly form the organic semiconductor layers 14 for eliminating the effect of unevenness of the surface of the buffer layer 13, the organic semiconductor layers 14 may be made thinner than conventional thicknesses. As a result, it is possible to reduce the usage of extremely expensive organic raw materials so as to lower production cost.

Optionally, the reflective layer 18 may be provided between the metal foil 12 and the buffer layer 13. The reflective layer 18 is preferred to be composed of at least one selected from the group consisting of aluminum, aluminum alloys, silver, and silver alloys. These materials are suitable for a reflective layer due to a high optical reflectivity and also excellent in smoothness when being formed into thin films. In particular, aluminum and aluminum alloys are preferable, because they are inexpensive materials. A wide variety of aluminum alloys and silver alloys can be adopted having conventional alloy compositions for use as an anode or a cathode of a device such as an organic solar cell, an organic EL element. Preferred examples of the aluminum alloy compositions include Al-Ni; Al-Cu; Al-Ag; Al-Ce; Al-Zn; Al-B; Al-Ta; Al-Nd; Al-Si; Al-La; Al-Co; Al-Ge; Al-Fe; Al-Li; Al-Mg; and Al-Mn. Any element that can constitute these alloys may be combined arbitrarily, depending on required performances. Preferred examples of the silver alloy compositions include Ag-Pd; Ag-Cu; Ag-Al; Ag-Zn; Ag-Mg; Ag-Mn; Ag-Cr; Ag-Ti; Ag-Ta; Ag-Co; Ag-Si; Ag-Ge; Ag-Li; Ag-B; Ag-Pt; Ag-Fe; Ag-Nd; Ag-La; and Ag-Ce. Any element that can constitute these alloys may be combined arbitrarily, depending on required performances. The thickness of the reflective layer 18 is not particularly limited, but is preferably from 50 nm to 500 nm, more preferably from 100 nm to 300 nm.

According to a preferred embodiment of the present invention, various known organic semiconductor layer structures used for organic solar cells may be used as the organic semiconductor layers 14, and the organic semiconductor layers are preferred to be capable of providing current due to generation of potential difference by receiving light within the wavelength range of 2000 nm to 250 nm. For example, as the organic semiconductor layers 14, a hole transport layer (PEDOT: PSS (30 nm)) and a power generation layer (e.g. a composite membrane of PCBM (fullerene derivative) and P3HT (poly(3-hexylthiophene))) may be laminated on the metal foil 12 in this order. Known materials may be appropriately used for each of these layers without any particular limitation. Furthermore, in order to prevent short circuit between electrodes and to improve power generation efficiency by absorbing light sufficiently, the thickness of the organic semiconductor layers 14 is preferred to be within the range of 50 nm to 1000 nm, more preferably within the range of 100 nm to 800 nm, further preferably within the range of 200 nm to 500 nm.

According to another preferred embodiment of the present invention, as the organic semiconductor layers 14, various known EL layer structures used for organic EL elements may be used, in which optionally a hole injection layer and/or a hole transport layer, a light-emitting layer, and optionally an electron transport layer and/or an electron injection layer may be laminated in this order. Any various known structures or compositions may be appropriately employed for each of the hole injection layer, the hole transport layer, the light-emitting layer, the electron transport layer, and the electron injection layer, without any particular limitation.

The counter electrode 16 provided on the organic semiconductor layers 14 is preferably formed with a translucent metal layer and/or a transparent oxide layer due to the necessity to transmit light. A particularly preferable counter electrode 16 has a two-layer structure in which a transparent oxide layer as a cathode layer composed of an conductive oxide film is laminated onto a translucent metal layer as a buffer layer composed of a magnesium alloy film and/or a fluoride film, being highly useful from the viewpoint of resistance as well. In this case, a high optical transparency and a low work function are provided by bringing the translucent metal layer (buffer layer) of the counter electrode 16 into contact with the organic semiconductor layers 14, thereby, for example when it is used in a solar cell, enhancing power generation efficiency. Most preferable examples include a cathode structure formed by laminating a translucent metal layer (buffer layer) composed of Mg-Ag and a transparent oxide layer (cathode layer) composed of IZO (indium zinc oxide); and cathode structure formed by laminating a translucent metal layer (buffer layer) composed of Al-Li and a translucent metal layer (cathode layer) composed of Ag. In addition, the counter electrode 16 may have two or more transparent oxide layers and/or two or more translucent metal layers.

The extraction electrode provided at the end of the counter electrode 16 may be constructed of the same materials as the counter electrode 16, or may be constructed by adequately selecting from conductive materials compatible with the materials of the counter electrode 16. The extraction electrode may be formed integrally with the counter electrode 16 at the same time as formation of the counter electrode 16, or may be formed aside from the counter electrode 16.

The sealing material 17 is provided on the counter electrode 16. The gap between the sealing material 17 and the counter electrode 16 may be filled with a sealing resin to form a sealing film. As the sealing material 17, glass; or films made from organic substances may be used. In the case of glass, the sealing material may be bonded directly onto the sealing film using a hydrophobic adhesive tape. In the case of films, both surfaces and end faces thereof may be covered with a Si-based insulating film. When a film having a high barrier performance will be developed in future, sealing will be possible without conducting coating treatment, and is expected to provide superior mass productivity. As the sealing material 17, films are preferable in terms of imparting flexibility. Nonetheless, a desired performance may be attained by using a sealing material formed by bonding a film to an extremely thin glass having a thickness of from 20 µm to 100 µm. Furthermore, as the sealing film, resins or silicon nitride may be used.

The interlayer insulation film 19 may be provided between adjacent organic semiconductor layers 14 on the metal foil 12. Although various known interlayer insulation films may be used as the interlayer insulation film 19, a Si-based insulation film formed by CVD is preferable in that the film has a high barrier performance against water and oxygen that cause degradation of organic layers. A SiN-based insulation film is more preferable. A still more preferable interlayer insulation film is a SiNO-based insulation film in that the film has a small internal stress and an excellent bending performance. Furthermore, resins such as polyimide may be used as the interlayer insulation film 19. In consideration of materials, process cost and ease of cutting, when resins having high humidity resistance and sealability will be developed in future, a resin-based insulation film will be preferably used. In addition, these films may be combined adequately.

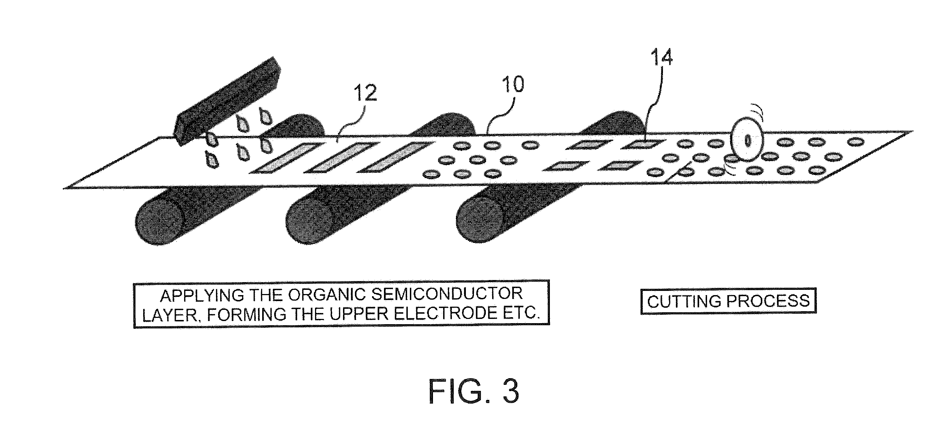

Since the electrode foil 10 of the present invention is based on the metal foil 12, the electrode foil 10 can be produced efficiently, for example, by roll-to-roll process without particularly necessitating a supporting base material. As shown in Fig. 3, by roll-to-roll process, the organic semiconductor layers 14, the counter electrode 16 as shown in Fig. 1 or Fig. 2, and the like can be formed on the metal foil 12, for example, in stripe form or matrix form. The arrangement of the organic semiconductor layers 14 and the like on the metal foil 12 is not limited to that shown in Fig. 3, and the organic semiconductor layers and the like may be freely arranged on the metal foil 12.

The electrode sheet 10 of the present invention may be used preferably as a component of various kinds of organic devices (particularly, flexible light-emitting or power generating devices). Examples of such organic devices include organic EL elements; organic EL lighting; organic EL displays; electronic paper; thin-film solar cells; liquid crystal displays; inorganic EL elements; inorganic EL displays; LED lighting; and LED displays. Preferred are organic EL elements, organic EL lighting, organic EL displays, organic solar cells, and dye-sensitized solar cells. Namely, in the electrode sheet 10 of the present invention, appropriate selection of the kind of organic semiconductor layers 14 to be laminated on the metal foil 12 in accordance with known techniques makes it possible to construct an organic device in any form of an organic EL element and an organic solar cell.

### Organic device module

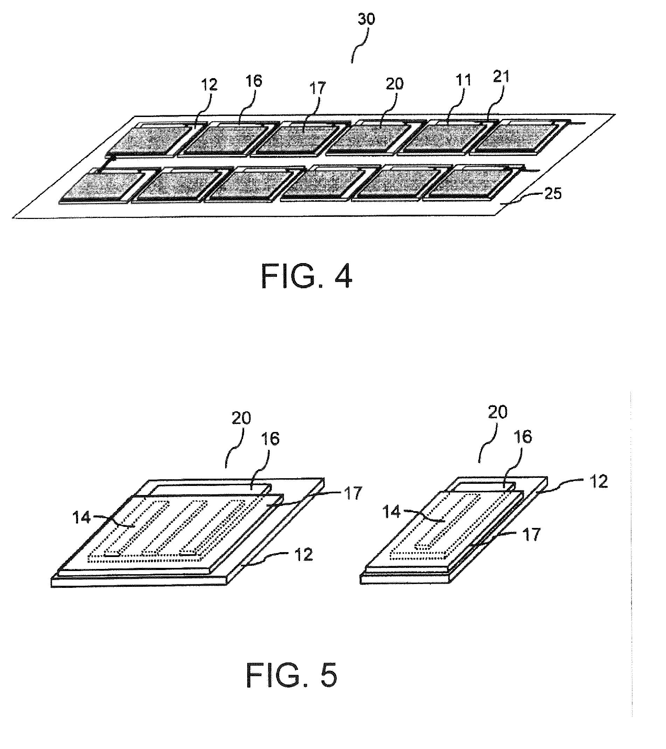

Fig. 4 illustrates an example of an organic device module 30 for organic solar cells in which the electrode sheet 10 according to the present invention is used as the structural member. Fig. 4 is a schematic view for the purpose of description and understanding of the embodiment. Shapes, dimensions, ratios, and the like in the view can appropriately be changed by taking the following descriptions and known techniques into consideration.

In the organic solar cell module 30, a plurality of cells 20 as organic device elements obtained by cutting the electrode sheet 10 of the present invention at separation sections between the organic semiconductor layers 14 are arranged on an insulating substrate 25 and the cells 20 are electrically connected each other with an electrical wiring 21.

As shown in Fig. 5, each cell 20 as organic device element is obtained by cutting the electrode sheet 10 at separation sections between the organic semiconductor layers 14, using a commercially available cutting machine. As described above, since the electrode sheet 10 can be easily cut, the cells 20 are not limited to quadrangular shapes shown in Figs. 4 and 5 and may be formed in various shapes such as circle, triangle and polygon. Furthermore, the number of the organic semiconductor layers 14 provided in each cell 20 is not limited to one or three shown in Fig. 5 and, in order to ensure desired current density, may be selected adequately. Moreover, upon cutting the electrode sheet 10, the organic semiconductor layers 14 are preferably not exposed at end faces so as to prevent degradation of the organic semiconductor layers 14 due to invaded water, oxygen and the like from the outside.

The insulating substrate 25 may be, for example, a resin material and glass with thickness of around 1 mm, but should not be particularly limited as long as it is the substrate of which at least surface has insulation properties. The insulating substrate 25 preferably has flexibility. Furthermore, from the viewpoint of cost and production, as the insulating substrate 25, a resin film is preferably used. Examples of such a resin film include polyethylene terephthalate (PET), polyimide (PI), polycarbonate (PC), polyethersulfone (PES), and polyethernitrile (PEN).

Each cell 20 arranged on the insulating substrate 25 may be electrically connected to each other by means of the electrical wiring 21. When used as an organic solar cell, by electrically series-connecting each cell 20, a desired voltage can be obtained. As the electrical wiring 21, a conductive paste, an electric wire, a printed circuit or the like may be used. The connection form between the cells 20 is not limited to the series connection as described above and, according to a use application of the organic device module 30, various connection forms may be used.

Since the organic device module 30 using the electrode sheet 10 of the present invention is made using the cells 20 obtained by cutting the electrode sheet 10, a photolithography process is not required. Therefore, complication of the manufacturing processes and eventually increase of the production cost can be avoided. Furthermore, since, after cutting a plurality of cells 20 separately, each cell 20 is series-connected, a defective cell can be removed beforehand and performance degradation of the entire organic device module 30 as organic solar cell can be avoided.

Moreover, a top-emission type organic EL module using the electrode sheet 10 of the present invention as the component may be constructed by replacing the organic semiconductor layers 14 with known organic EL layers. In the case of an organic EL module in which the metal foil 12 of the electrode sheet 10 according to the present invention is used as an anode, it is preferred that the buffer layer 13 be composed of a conductive amorphous carbon film or a conductive oxide film so as to be suitable as the anode. Furthermore, in the case of an organic EL module in which the metal foil 12 of the electrode sheet 10 according to the present invention is used as a cathode, it is preferable that, for the buffer layer 13, a magnesium alloy film or a fluoride film be formed by sputtering or vapor deposition and that, for the counter electrode 16 as an anode, a conductive amorphous carbon, MoO₃, or V₂O₅ be formed by vapor deposition. In particular, in the case of forming a conductive amorphous carbon film on the organic EL layer, vacuum deposition is preferably used in order to avoid plasma damage during sputtering.

### EXAMPLES

The present invention will be further described in detail with reference to the following examples.

### Example 1: Preparation of electrode sheet (Cu/graphene/organic semiconductor)

An electrode sheet for organic solar cells with the structure as shown in Fig. 1 comprising the copper foil as an anode was prepared as follows. First, 64 µm thick commercially available both-side-flat electrolytic copper foil (DFF (Dual Flat Foil), manufactured by Mitsui Mining & Smelting Co., Ltd.) was provided as a metal foil 12. The surface roughness of the copper foil was measured with a scanning probe microscope (Nano Scope V, manufactured by Veeco Instrument Inc.) in accordance with JIS B0601-2001, resulting in an arithmetic average roughness Ra of 12.20 nm. This measurement was performed in an area of 10 µm square using a Tapping Mode AFM.

The copper foil was subjected to CMP treatment with a polishing machine manufactured by MAT Inc. This CMP treatment was performed by using a polishing pad having XY grooves and a colloidal silica polishing liquid under the conditions of pad rotation speed of 30 rpm; load of 200 gf/cm²; and liquid supply rate of 100 cc/min. The copper foil thus treated with CMP was subjected to measurement of the surface roughness of the copper foil by using the scanning probe microscope (Nano Scope V, manufactured by Veeco Instruments Inc.) in accordance with JIS B 0601-2001, resulting in an arithmetic average roughness Ra of 0.7 nm. This measurement was performed in an area of 10 µm square using a Tapping Mode AFM. The thickness of the copper foil after the CMP treatment was 48 µm.

On the surface of the copper foil treated with CMP, a graphene film as the buffer layer 13 was formed in a gold furnace by thermal CVD. The gold furnace comprises a silica tube (a reaction tube) of 200mm in diameter covered with a gold-evaporated glass tube, and is connected to a turbo molecular pump, a mechanical booster pump and a rotary pump. The silica tube was evacuated in a vacuum state to 5 × 10⁻⁶ Torr or less with the turbo molecular pump. A valve between the turbo molecular pump and the furnace was closed, and, at a flow rate of CH₄/H₂ = 25/10sccm under the condition that the copper foil was heated to 1,000 °C, a valve between the mechanical booster pump and the furnace was adjusted so as to provide a pressure of about 0.5 Torr. A reaction was conducted under this condition for 30 minutes, before cooling at a rate 10 °C/sec. The cooling was achieved under hydrogen atmosphere at a pressure of about 0.1 Torr.

On the copper foil with graphene thus obtained, an interlayer insulation film 19 composed of silicon nitride was formed by plasma CVD. This plasma CVD was performed under the conditions of film forming area of 8 inch diameter in terms of effective area; input power(RF) of 250 W (0.8 W/cm²); ultimate vacuum of lower than 5×10⁻³ Pa; sputtering pressure of 80 Pa; atmosphere of SiH₄ (diluted with H₂ to 10%):NH₃:N₂ = 100:10:200 sccm; and substrate temperature at 250 °C, using a plasma CVD apparatus (PD-2202L, manufactured by Samco Inc.) to which a mechanical booster pump (MBP) and a rotary pump (RP) were connected. The surface of the laminated foil was cleansed with isopropyl alcohol solution heated to a temperature in the range of from 40 to 50 °C and dried using nitrogen gas.

On the buffer layer 13 thus cleansed, three separate organic semiconductor layers 14, a counter electrode 16 as a cathode, a sealing film 15 and a sealing material 17 were laminated as follows. First, on three light-receiving sections of the buffer layer 13 surface, poly (3,4-ethylenedioxythiophene) - poly (styrenesulfonic acid) (PEDOT:PSS) dispersion solution (1.3 % by weight) was applied by spin coating at a rotation speed of 5000 rpm. The applied electrode sheet was dried on a hot plate at 180 °C for 30 minutes.

In turn, P3HT and PCBM supplied by Sigma-Aldrich Co. were added respectively to a chlorobenzene solution at the rate of 10 mg/ml, and then kept at about 25 °C for 24 hours so as to be completely dissolved. The mixed chlorobenzene solution of P3HT and PCBM was applied by spin coating at a rotation speed of 1000 rpm, and the organic semiconductor layers 14 with a thickness of 100 nm were obtained. After that, calcination was performed at 150 °C for 30 minutes under an inert atmosphere such as Ar, and then by using vacuum deposition method, on the organic semiconductor layers 14, Al - Li film with a thickness of 10 nm and Ag film with a thickness of 10 nm were sequentially formed as the counter electrode 16 which covered three organic semiconductor layers 14. Furthermore, at the end of the counter electrode 16, Ag film as an extraction electrode was formed by vacuum deposition method so as not to make contact with the organic semiconductor layers 14.

### Example 2: Preparation of organic solar cell module

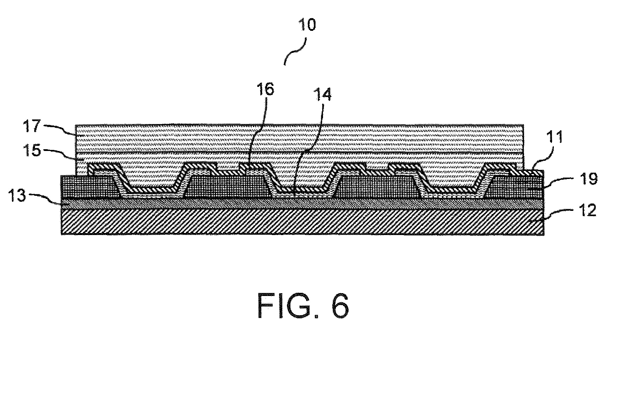

An electrode sheet 10 for organic solar cells with the structure as shown in Fig. 6 comprising the copper foil 12 as an anode was prepared as follows. First, a copper foil with graphene was prepared in the same manner as in Example 1. On the copper foil with graphene, a plurality of thin glasses with a thickness of 0.1 mm, a width of 2 mm and a length of 10 mm were arranged at 2 mm intervals and a part to be light-receiving section was masked. While keeping this condition, an interlayer insulation film 19 composed of silicon nitride was formed by plasma CVD. This plasma CVD was performed under the conditions of film forming area of 8 inch diameter in terms of effective area; input power(RF) of 250 W (0.8 W/cm²); ultimate vacuum of lower than 5×10⁻³ Pa; sputtering pressure of 80 Pa; atmosphere of SiH₄ (diluted with H₂ to 10%): NH₃:N₂ = 100:10:200 sccm; and substrate temperature at 250 °C, using a plasma CVD apparatus (PD-2202L, manufactured by Samco Inc.) to which a mechanical booster pump (MBP) and a rotary pump (RP) were connected. After that, the thin glasses were removed, and then the surface of the laminated foil was cleansed with isopropyl alcohol solution heated to a temperature in the range of from 40 to 50 °C and dried using nitrogen gas.

On the buffer layer 13 thus cleansed, a plurality of separate organic semiconductor layers 14, a counter electrode 16 as a cathode, a sealing film 15 and a sealing material 17 were laminated as follows. First, on a plurality of separate light-receiving sections of the buffer layer 13 surface, poly (3,4-ethylenedioxythiophene) - poly (styrenesulfonic acid) (PEDOT:PSS) dispersion solution (1.3 % by weight) was applied by spin coating at a rotation speed of 5000 rpm. The applied electrode sheet was dried on a hot plate at 180 °C for 30 minutes.

In turn, P3HT and PCBM supplied by Sigma-Aldrich Co. were added respectively to a chlorobenzene solution at the rate of 10 mg/ml, and then kept at about 25 °C for 24 hours so as to be completely dissolved. The mixed chlorobenzene solution of P3HT and PCBM was applied by spin coating at a rotation speed of 1500 rpm, and the organic semiconductor layers 14 with a thickness of 100 nm were obtained. On the organic semiconductor layers 14, Mg-Ag translucent layer with a thickness of 10 nm (Mg:Ag=1:9) and IZO (In-Zn-O) transparent oxide layer with a thickness of 100 nm were formed as the counter electrode 16. The Mg-Ag translucent layer and the IZO transparent oxide layer as the counter electrode 16 were formed so as to cover the plurality of separate organic semiconductor layers 14. Furthermore, as an extraction electrode at the end of the IZO transparent oxide layer, the IZO transparent oxide layer was formed on the interlayer insulation film 19 so as not to make contact with the organic semiconductor layers 14. After that, calcination was performed at 150 °C for 30 minutes under an inert atmosphere such as Ar.

On the electrode sheet thus obtained, a silicon nitride passivation film (a sealing layer) 15 with a thickness of 300 nm and an organic layer (the sealing material) 17 with a thickness of 2000 nm were laminated in this order. Then, the passivation film 15 and the organic layer 17 were laminated so as to expose the extraction electrode at the end of the IZO transparent oxide layer without completely covering it. In this way, there was obtained the electrode sheet 10 as shown in Fig. 6.

In turn, a plurality of cells 20 were prepared by cutting the electrode sheet 10 at isolated sections between the organic semiconductor layers 14, with commercially available scissors. This cutting was performed so that each cell 20 had three organic semiconductor layers 14 (light-receiving surfaces) in order to ensure the current density and that the organic semiconductor layers 14 were not exposed at the end faces.

As shown in Fig. 4, the plurality of cell 20 were arranged at 3 mm intervals, on a polyimide substrate with a thickness of 250 nm as the insulating substrate 25. And then the extraction electrodes of each cell 20 which were formed so as to be exposed from the sealing film 15 and the sealing material 17, and the metal foil 12 corresponding to a back side of cell 20 adjacent thereto, were connected by using a silver paste as the electric wiring 21 so that each cell 20 was arranged in electrical series. By performing such connections successively, the solar cell module 30 as shown in Fig. 4 which has desired voltage can be obtained.

### Example 3: Preparation of electrode sheet (Cu/Al alloy/a-C/organic semiconductor)

An electrode sheet for organic EL with the structure as shown in Fig. 2 comprising the copper foil as an anode was prepared as follows. First, in the same manner as in Example 1, on the surface of the copper foil 12 treated with CMP, an Al alloy reflective layer 18 with a thickness of 150 nm was formed by sputtering. This sputtering was performed under the conditions of input power (DC) of 1,000 W (3.1 W/cm²); ultimate vacuum of lower than 5x10⁻⁵ Pa; sputtering pressure of 0.5 Pa; Ar flow rate of 100 sccm; and substrate temperature of room temperature, after mounting an aluminum alloy target (203.2 mm diameter and 8 mm thick) having a composition of Al-0.2B-3.2Ni (at%) in a magnetron sputtering apparatus (MSL-464, manufactured by Tokki Corp.) to which a cryopump was connected.

On the surface of an Al alloy reflective layer 18 thus obtained, a carbon buffer layer 13 with a thickness of 1.7 nm was formed by sputtering. As a carbon target for the sputtering, a non-treated carbon target with a purity of 3N (99.9%) made from a carbon material (IGS743, manufactured by Tokai Carbon Co., Ltd.), or a carbon target having a purity of 5N (99.999%) made from the above carbon material through purification treatment with a halogen gas was used. This sputtering was performed under the conditions of input power (DC) of 250 W (0.8 W/cm²); ultimate vacuum of lower than 5x10⁻⁵ Pa; sputtering pressure of 0.5 Pa; Ar flow rate of 100 sccm; and substrate temperature at room temperature, after mounting the carbon target (203.2 mm diameter and 8 mm thick) in a magnetron sputtering apparatus (Multi-chamber sheet-fed-type film formation apparatus MSL-464, manufactured by Tokki Corp.) to which a cryopump was connected. The film thickness was controlled by regulating discharging time.

In turn, a glass plate (3 cm square and 0.5 mm thick) was put on the carbon buffer layer 13 (5 cm square) so as to make masking, followed by formation of an interlayer insulation film 19 composed of silicon nitride by plasma CVD (Chemical Vapor Deposition). This plasma CVD is performed under the conditions of film forming area of 8 inch diameter in terms of effective area; input power(RF) of 250 W (0.8 W/cm²); ultimate vacuum of lower than 5×10⁻³ Pa; sputtering pressure of 80 Pa; gas flow rate of SiH₄ (diluted with H₂ to 10%):NH₃:N₂ = 100:10:200 sccm; and substrate temperature at 250°C, using a plasma CVD apparatus (PD-2202L, manufactured by Samco Inc.) to which a mechanical booster pump (MBP) and a rotary pump (RP) are connected. The glass was then removed from the carbon buffer layer 13 to obtain an interlayer insulation film 19 having an opening of 3 cm square on the carbon buffer layer 13.

The surface of the carbon buffer layer 13 having the interlayer insulation film 19 formed thereon was cleansed as follows. First, ultrasonic cleansing for 3 minute was performed twice in a bath filled with an ultrapure water (having larger than 18.0 MΩ) being replaced with a fresh one for the second cleansing. Subsequently, after water was removed by using nitrogen gas, after-curing was performed at 100°C for 3 hours. The surface thus treated was cleansed by UV irradiation.

On the carbon buffer layer 13 thus cleansed, an organic EL layer 14, a counter electrode 16 as a cathode, a sealing film 15, and a sealing material 17 were laminated. Specifically, on the surface of the carbon buffer layer 13, a 50-nm-thick hole injection layer composed of copper phthalocyanine, a 40-nm-thick hole transport layer composed of 4,4'-bis(N,N'-(3-tolyl)amino)-3,3'-dimethylbiphenyl (HMTPD), a 30-nm-thick light emitting layer composed of a host material doped with tris(2-phenylpyridine) iridium complex (Ir(ppy)₃), a 30-nm-thick electron transport layer composed of Alq3, a 10-nm-thick translucent layer composed of Mg-Ag (Mg:Ag=1:9), a 100-nm-thick transparent oxide layer composed of IZO (In-Zn-O), a 300-nm-thick passivation film (a sealing layer) composed of silicon nitride, a 2,000-nm-thick adhesive layer, and a 200-µm-thick sealing glass (the sealing material) were laminated in this order. The lamination of the sealing glass was conducted by using a double-stick tape, which corresponds to the adhesive layer. In this way, there was obtained an electrode sheet 10 for organic EL as shown in Fig. 2, which was 50 mm square and 300 µm thick and had light-emitting area of 30 mm square respectively. This electrode sheet for organic EL was connected to a power source, and a light emission was observed.

### Example 4: Preparation of electrode sheet (Cu/Al/ITO/organic semiconductor)

An electrode sheet 10 for organic EL was prepared in the same manner as in Example 3 except that an ITO buffer layer with a thickness of 10 nm was formed by sputtering in place of the carbon buffer layer. This sputtering was performed under the conditions of input power (DC) of 600 W (1.9 W/cm²); ultimate vacuum of lower than 5x10⁻⁵ Pa; sputtering pressure of 0.5 Pa; Ar flow rate of 100 sccm; O₂ flow rate of 2 sccm; and substrate temperature at room temperature, after mounting an ITO (In₂O₃-SnO₂) target (710 mm and 630 mm thick) containing 10 wt% of Sn in a magnetron sputtering apparatus (SMD-450, manufactured by ULVAC, Inc.) to which a cryopump was connected. The electrode sheet for organic EL thus obtained was connected to a power source, and a light emission was observed.

### Example 5: Preparation of electrode sheet (Cu/Ag-alloy/a-C/organic semiconductor)

An electrode sheet 10 for organic EL was prepared in the same manner as in Example 3 except that an Ag alloy reflective layer with a thickness of 150 nm was formed by sputtering in place of the Al alloy reflective layer. This sputtering was performed under the conditions of input power (DC) of 150 W (1.9 W/cm²); ultimate vacuum of lower than 5x10⁻⁵ Pa; sputtering pressure of 0.5 Pa; Ar flow rate of 90 sccm; and substrate temperature at room temperature, after mounting a silver alloy target (101.6 mm diameter and 5 mm thick) having a composition of Ag-1.0Cu-1.0Pd (at%) on a magnetron sputtering apparatus (MSL-464, manufactured by Tokki Corp.) to which a cryopump was connected. The electrode sheet for organic EL thus obtained was connected to a power source, and a light emission was observed.

### Example 6: Preparation of electrode sheet (Cu/Al-alloy/organic semiconductor)

An electrode sheet for organic EL comprising the copper foil as a part of a cathode was prepared as follows. First, on the copper foil prepared under the same conditions as in Example 1, an Al alloy reflective layer with a thickness of 150 nm was formed by sputtering. This sputtering was performed under the conditions of input power (DC) of 1,000 W (3.1 W/cm²); ultimate vacuum of lower than 5x10⁻⁵ Pa; sputtering pressure of 0.5 Pa; Ar flow rate of 100 sccm; and substrate temperature of room temperature, after mounting an aluminum alloy target (203.2 nm diameter and 8 mm thick) having a composition of Al-4Mg (at%) in a magnetron sputtering apparatus (MSL-464, manufactured by Tokki Corp.) to which a cryopump was connected.

In turn, a glass plate (3 cm square and 0.5 mm thick) was put on the Al alloy reflection film (5 cm square) so as to make masking, followed by formation of an interlayer insulation film 19 composed of silicon nitride by plasma CVD (Chemical Vapor Deposition). This plasma CVD was performed under the conditions of film forming area of 8 inch diameter in terms of effective area; input power(RF) of 250 W (0.8 W/cm²); ultimate vacuum of lower than 5x10⁻³ Pa; sputtering pressure of 80 Pa; gas flow rate of SiH₄ (diluted with H₂ to 10%):NH₃:N₂ = 100:10:200 sccm; and substrate temperature at 250°C, using a plasma CVD apparatus (PD-2202L, manufactured by Samco Inc.) to which a mechanical booster pump (MBP) and a rotary pump (RP) were connected. The glass was then removed from the Al alloy reflection film to obtain an interlayer insulation film 19 having an opening of 3 cm square.

Furthermore, on the cleansed Al alloy reflection film, an organic EL layer, an anode, a sealing layer, and a sealing material were laminated. Specifically, on the Al alloy reflective layer surface, a 50-nm-thick α-NPD layer, a 50-nm-thick Alq3 layer, a 20-nm-thick MoO₃ layer, a 100-nm-thick transparent oxide layer composed of IZO (In-Zn-O), a 300-nm-thick passivation film (a sealing film) composed of silicon nitride, a 2,000-nm-thick adhesive layer, and a 200-µm-thick sealing glass (the sealing material) were laminated in this order. The lamination of the sealing glass was conducted by using a double-stick tape. The double-stick tape corresponds to the adhesive layer. The electrode sheet for organic EL thus obtained was connected to a power source, and a green light emission due to Alq3 was observed.

## Claims

1. An electrode sheet for organic device comprising:
a metal foil;
a plurality of organic semiconductor layers provided apart from each other on said metal foil.

2. The electrode sheet according to claim 1, wherein the electrode sheet is used as a structural member of an organic EL element or an organic solar cell.

3. The electrode sheet according to claim 1 or 2, wherein the organic semiconductor layers side surface of said electrode sheet is an ultra-smooth surface having an arithmetic average roughness Ra of 10.0 nm or less, said arithmetic average roughness Ra being measured in accordance with JIS B 0601-2001.

4. The electrode sheet according to any one of claims 1 to 3, wherein said metal foil has a thickness of from 1 µm to 200 µm.

5. The electrode sheet according to any one of claims 1 to 4, wherein said metal foil is a copper foil.

6. The electrode sheet according to any one of claims 1 to 5, further comprising an interlayer insulation film between said adjacent organic semiconductor layers.

7. The electrode sheet according to claim 6, wherein said interlayer insulation film comprises an organic insulating film.

8. The electrode sheet according to any one of claims 1 to 7, further comprising a transparent or translucent buffer layer between said metal foil and said organic semiconductor layers.

9. The electrode sheet according to claim 8, wherein said buffer layer comprises a conductive carbon material film, a conductive oxide film, a magnesium alloy film, and a fluoride film.

10. The electrode sheet according to claim 9, wherein said conductive carbon material film is a graphene film or a conductive amorphous carbon film.

11. The electrode sheet according to any one of claims 8 to 10, further comprising a reflective layer between said metal foil and said buffer layer.

12. The electrode sheet according to claim 11, wherein said reflective layer is at least one selected from the group consisting of an aluminum film, an aluminum alloy film, a silver film, and a silver alloy film.

13. The electrode sheet according to any one of claims 1 to 12, further comprising a counter electrode covering the surface of the plurality of organic semiconductor layers.

14. The electrode sheet according to any one of claims 1 to 13 for being cut at separation sections between said organic semiconductor layers to provide a plurality of organic device elements for use in an organic device module.

15. An organic device module comprising a plurality of organic device elements on an insulating substrate, the plurality of organic device elements having been obtained by cutting the electrode sheet according to any one of claims 1 to 14 at separation sections between said organic semiconductor layers.

16. The organic device module according to claim 15, wherein the organic device module is used as an organic EL module or an organic solar cell module.

17. A method for producing an organic device module comprising the steps of:
cutting the electrode sheet according to any one of claims 1 to 14 at separation sections between said organic semiconductor layers to form a plurality of organic device elements; and
arranging the plurality of organic device elements on an insulating substrate.
